# FASCICULE DE BREVET EUROPEEN

(11) **EP 2 602 937 B1**
(45) Date de publication et mention de la délivrance du brevet: **29.10.2014**
(21) Numéro de dépôt: 12195280.8
(22) Date de dépôt: 03.12.2012
(51) Int. Cl.: H03M 1/06, H03M 1/10, G06N 3/063, H03M 1/74

(54) **Convertisseur numérique-analogique et circuit neuromorphique utilisant un tel convertisseur**
Digital-Analog-Wandler und neuromorpher Schaltkreis, bei dem dieser Wandler eingesetzt wird
Digital-to-analog converter and neuromorphic circuit using such a converter

(30) Priorité: 05.12.2011 FR 1161145
(43) Date de publication de la demande: 12.06.2013
(73) Titulaire: COMMISSARIAT A L'ENERGIE ATOMIQUE ET AUX ENERGIES ALTERNATIVES, 75015 Paris (FR)
(72) Inventeur: Heliot, Rodolphe, 38000 GRENOBLE (FR); Jehl, Xavier, 38360 NOYAREY (FR); Sanquer, Marc, 38700 CORENC (FR); Wacquez, Romain, 38000 GRENOBLE (FR)
(74) Mandataire: Guérin, Michel

(56) Documents cités:
- US-A1- 2003 231 124

## Description

L'invention concerne d'une part un nouveau type de convertisseur numérique-analogique et d'autre part un circuit électronique à architecture neuromorphique utilisant un tel convertisseur. Le convertisseur numérique-analogique est tout spécialement conçu pour une utilisation dans le contexte d'un circuit neuromorphique mais il peut avoir également d'autres utilisations. Il va être décrit dans ce contexte pour lequel il a été conçu.

Les circuits neuromorphiques sont des réseaux de multiples cellules, configurés de manière à imiter un peu le comportement des réseaux de neurones biologiques. Les réseaux de neurones biologiques comportent des neurones élémentaires qui reçoivent et émettent de l'information, et des synapses qui connectent ces neurones à d'autres neurones. Par analogie, les circuits neuromorphiques comprennent en général un réseau matriciel de cellules élémentaires de traitement qu'on appellera neurones, identifiés chacun par une adresse respective dans la mémoire, et une mémoire matricielle d'autant de mémoires élémentaires qu'il y a de neurones ; chaque mémoire élémentaire est associée à un neurone et peut donc être identifiée par l'adresse unique de ce neurone ; elle contient des adresses d'autres neurones qui doivent recevoir une information en provenance du neurone correspondant à cette mémoire élémentaire.

On considère dans ce qui suit les neurones dits "à décharge". Ces neurones reçoivent des signaux d'entrée en provenance d'autres neurones ; ils les traitent sous forme généralement analogique et produisent un résultat. Le résultat peut être l'émission d'un signal d'évènement, par exemple une impulsion à un moment donné. C'est cette impulsion, dite de "décharge du neurone", qui sert à aller chercher dans la mémoire élémentaire associée au neurone non seulement les adresses d'autres neurones (neurones-cible ou neurones de destination), mais aussi des poids associés à chacune de ces adresses. Les poids associés signifient qu'un neurone va influencer un ou plusieurs autres neurones de manière pondérée et non de manière indifférenciée.

Les adresses des neurones influencés par un neurone sont appelées adresses post-synaptiques ; les poids associés sont appelés poids synaptiques.

Par exemple, un neurone élémentaire analogique peut être constitué sous forme d'un intégrateur temporel à fuite ; son potentiel interne représente la somme algébriques de plusieurs potentiels appliqués au fil du temps à ses entrées par d'autres neurones, cette somme étant affectée par des courants de fuite ; lorsque le potentiel interne atteint un certain seuil, le neurone signale cet évènement en émettant un signal d'évènement qui est une impulsion de très courte durée, souvent appelé "spike". Le potentiel revient alors à un état de repos, en attente de nouvelles entrées. Le signal d'évènement, ou spike, est utilisé, avec l'adresse du neurone qui l'a émis, pour extraire le contenu de la mémoire élémentaire associée à cette adresse ; ce contenu est constitué par une ou plusieurs adresses post-synaptiques et leurs poids synaptiques associés. Ces adresses et poids sont reçus par un circuit de traitement qui élabore des signaux d'entrée pondérés et qui les transmet en tant que signaux d'entrée aux neurones correspondant aux adresses post-synaptiques.

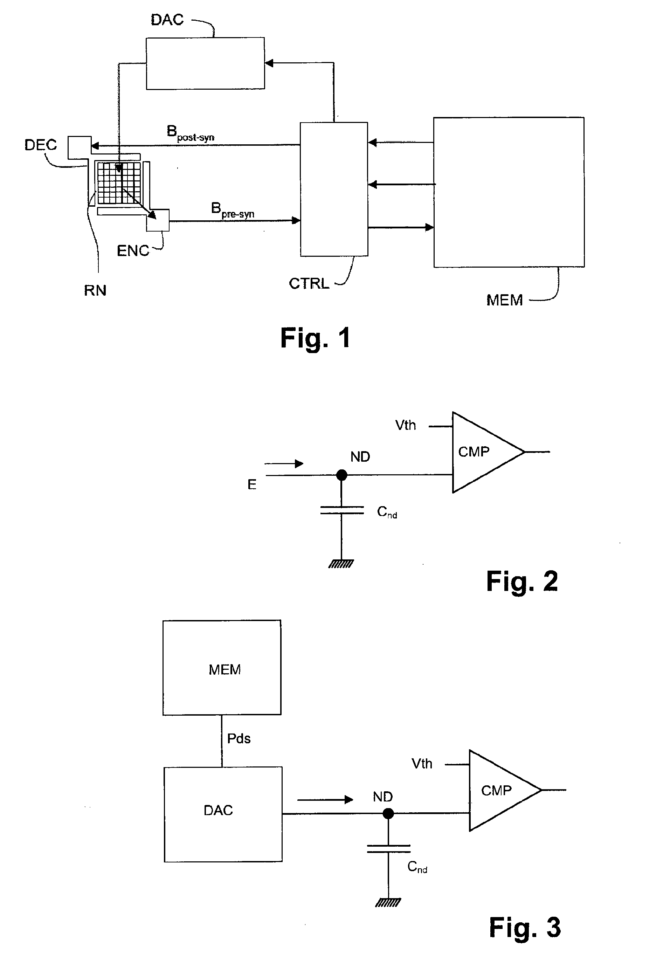

Dans la technique antérieure telle qu'illustrée sur la figure 1, le signal d'évènement issu de la décharge d'un neurone de la matrice de neurones RN est appliqué à un encodeur d'adresse ENC qui détermine l'adresse du neurone qui a généré l'évènement et qui envoie cette adresse sur un bus dit présynaptique B_{pre-syn}. Le bus pré-synaptique est un bus d'adresse pour la mémoire. Ce bus est géré par un contrôleur CTRL qui applique cette adresse à la mémoire MEM et qui recueille de la mémoire une ou plusieurs adresses post-synaptiques et les poids associés à chacune de celles-ci. Le contrôleur émet successivement les différentes adresses post-synaptiques sur un bus d'adresses post-synaptiques B_{post-syn} qui applique ces adresses à un décodeur d'adresses DEC associé à la matrice de neurones RN. En même temps, le contrôleur envoie les poids synaptiques à un convertisseur numérique analogique DAC qui établit des niveaux analogiques en fonction de chaque poids synaptique. Un niveau de signal analogique correspondant à un poids synaptique déterminé est donc appliqué à chacun des neurones post-synaptiques identifiés par le contenu de la mémoire élémentaire qui a été activée par le signal d'évènement.

Le neurone peut être schématisé comme sur la figure 2 par un noeud capacitif ND, de capacité C_{nd}. Ce noeud est connecté à l'entrée d'un comparateur à seuil CMP. L'entrée du neurone est constituée par une borne E reliée au noeud ND ; c'est une entrée en courant et le courant d'entrée sert à charger (ou décharger) la capacité. Par exemple, une impulsion de courant de largeur temporelle déterminée, positive ou négative, d'amplitude représentant un poids synaptique est appliquée à l'entrée E chaque fois que le neurone est désigné par un autre neurone. Par ailleurs, le noeud capacitif peut présenter des fuites de sorte que la capacité du noeud se décharge progressivement si de nouvelles impulsions de charge n'arrivent pas sur l'entrée E. Lorsque la tension aux bornes de la capacité augmente suffisamment pour atteindre le seuil du comparateur, celui-ci émet une impulsion brève qui est le signal d'évènement ou spike du neurone.

La figure 3 représente un neurone post-synaptique qui a été désigné par le bus post-synaptique et qui peut alors recevoir du convertisseur numérique-analogique DAC un signal analogique dont l'amplitude représente un poids synaptique. Ce signal est une impulsion brève de courant. Le poids synaptique Pds est contenu sous forme numérique dans la mémoire MEM, à l'adresse du neurone (pré-synaptique) qui a émis un spike à destination du neurone post-synaptique considéré ici. Le convertisseur numérique-analogique convertit ce poids numérique en une valeur de courant analogique émis pendant une impulsion de durée prédéfinie.

De nombreuses réalisations de convertisseurs numérique-analogique existent mais il est important de réaliser le convertisseur sous une forme particulièrement simple. L'invention a pour but de proposer un convertisseur numérique-analogique de construction simple et peu encombrante, utilisable tout particulièrement dans cette application de circuit neuromorphique.

L'invention repose sur le fait que les technologies de fabrication industrielle de circuits intégrés entraînent une dispersion non désirée, mais mise à profit ici, des caractéristiques individuelles des éléments du circuit intégré, et notamment des transistors. Ainsi, des transistors qui ont tous les mêmes caractéristiques géométriques nominales devraient tous fournir le même courant pour la même tension grille-source, mais fournissent en réalité des courants très différents les uns des autres. Cette dispersion est d'autant plus importante que les transistors sont plus petits ; or la technologie tend à évoluer vers des transistors de plus en plus petits, pour pouvoir maximiser le nombre de transistors sur une surface de circuit intégré donnée. La dispersion est particulièrement sensible pour des transistors de dimensions longueur par largeur inférieures à 40x100 nm², et encore plus pour 20x50 nm².

Le convertisseur numérique-analogique selon l'invention comporte:
- un ensemble de plusieurs transistors de caractéristiques géométriques nominales identiques mais de caractéristiques courant-tension dispersées telles que lorsqu'on applique une tension grille-source constante aux différents transistors il circule dans le transistor un courant variable en fonction de la dispersion,
- une table numérique de correspondance ayant une entrée numérique pour recevoir un mot à convertir et une sortie de sélection pour sélectionner parmi l'ensemble de transistors, en fonction du mot à convertir, un transistor ou un groupe de transistors fournissant un courant de valeur désirée représentant ce mot sous forme analogique,
- une sortie en courant fournissant le courant délivré par le transistor ou le groupe de transistors sélectionnés, recevant tous une tension grille-source nominale,
- et des moyens pour charger dans la table numérique de correspondance à une adresse déterminée une donnée déterminant la sélection du transistor ou du groupe de transistors, en fonction de caractéristiques courant-tension réelles mesurées des différents transistors de l'ensemble, pour établir une correspondance entre des mots à convertir et des valeurs de courant obtenues par la sélection des transistors, la table de correspondance étant différente de celle qu'on aurait si les transistors avaient tous les dites caractéristiques nominales.

De préférence, la tension grille-source appliquée aux transistors est une tension inférieure à la tension Vt de seuil de mise en conduction des transistors.

De préférence, la sortie de sélection de la table de correspondance comprend plusieurs conducteurs de sortie connectés chacun au drain d'un transistor respectif, les sources des transistors étant toutes reliées à la sortie du convertisseur, de sorte que la sortie du convertisseur fournit la somme des courants traversant ceux des transistors qui sont sélectionnés par la table, les autres transistors ne fournissant pas de courant.

Les conducteurs de sortie de la table peuvent avoir deux états qui sont un premier état en haute impédance dans lequel les drains des transistors ne reçoivent pas de tension d'alimentation et ne peuvent donc pas être parcourus par un courant, et un deuxième état dans lequel les drains des transistors reçoivent une alimentation et peuvent donc fournir un courant.

L'invention concerne également l'application principale pour laquelle ce convertisseur a été conçu, à savoir un circuit neuromorphique comprenant
- un réseau de neurones identifiés chacun par une adresse de neurone dans le réseau, chaque neurone pouvant recevoir et traiter au moins un signal d'entrée puis émettre plus tard sur une sortie du neurone un signal représentant un évènement qui se produit à l'intérieur du neurone,
- une mémoire programmable adressable par l'adresse d'un neurone ayant émis un signal d'évènement représentant un résultat de l'activité du neurone, la mémoire contenant à cette adresse une donnée numérique comprenant une ou plusieurs adresses de neurones post-synaptiques et un poids post-synaptique respectif associé à chaque adresse post-synaptique,
- des moyens pour extraire de la mémoire la donnée relative à un neurone, après que ce neurone ait émis un signal d'évènement représentant un résultat de l'activité du neurone,
- un convertisseur numérique-analogique pour appliquer à l'entrée d'un neurone post-synaptique identifié par une adresse contenue dans la donnée une impulsion de courant dont l'amplitude représente le poids post-synaptique associé à cette adresse dans la donnée,
**caractérisé en ce que** le convertisseur numérique-analogique comprend
- au moins un ensemble de plusieurs transistors de caractéristiques géométriques nominales identiques mais de caractéristiques courant-tension dispersées telles que lorsqu'on applique une tension grille source constante aux différents transistors il circule dans le transistor un courant variable en fonction de la dispersion,
- une table numérique de correspondance ayant une entrée numérique et une sortie de sélection pour sélectionner en fonction de l'entrée numérique un transistor ou un groupe de transistors parmi l'ensemble,
- une sortie en courant fournissant le courant délivré par le transistor ou le groupe de transistors sélectionnés, recevant tous une tension grille-source nominale,
- et des moyens pour charger dans la table numérique de correspondance des données déterminées déterminant la sélection de transistors, en fonction de caractéristiques courant-tension réelles mesurées des différents transistors de l'ensemble, la table de correspondance étant différente de celle qu'on aurait si les transistors avaient tous les dites caractéristiques nominales.

Dans une première réalisation, le convertisseur est commun à tous les neurones ; l'ensemble de transistors qui effectue la conversion en courant est commun à tous les neurones. La mémoire programmable envoie une adresse de neurone post-synaptique pour sélectionner ce neurone et elle envoie à la table de correspondance un mot numérique représentant le poids synaptique associé à ce neurone. La sortie en courant du convertisseur est appliquée au neurone post-synaptique désigné par la mémoire. Les neurones post-synaptiques sont activés successivement s'il y en a plusieurs, le convertisseur ne pouvant convertir qu'un poids synaptique à la fois.

Dans une autre réalisation, un convertisseur individuel est placé en amont de chaque neurone de sorte qu'il y a un ensemble de m transistors associé à chaque neurone et placé en amont du noeud capacitif du neurone ; s'il y a N neurones, il y a donc N ensembles de m transistors ; la table de correspondance est constituée par la mémoire programmable elle-même qui reçoit une adresse de neurone pré-synaptique ; cette adresse désigne au moins un neurone post-synaptique et désigne donc un ensemble de m transistors associé à ce neurone. Mais la table désigne non seulement cet ensemble mais plus précisément un transistor ou un groupe de transistors de l'ensemble ; en pratique, la table de correspondance adresse donc directement un transistor ou un groupe de transistors parmi mxN transistors. Le poids synaptique est inscrit dans la table non pas sous une forme de valeur numérique mais directement sous forme d'un code de sélection des transistors d'un ensemble. Avec cette structure, on peut appliquer simultanément à plusieurs neurones post-synaptiques les impulsions de courant ayant des amplitudes désirées.

D'une manière générale, la structure de circuit selon l'invention permet d'améliorer les performances en termes de consommation de puissance et de surface du circuit intégré.

On notera que le document de brevet US2003/231124 décrit un convertisseur utilisant plusieurs transistors de caractéristiques nominales identiques mais n'utilisant pas la dispersion des caractéristiques réelles. Bien au contraire, le convertisseur de ce document ne fonctionne correctement que si les transistors n'ont pas de dispersion de leurs caractéristiques.

D'autres caractéristiques et avantages de l'invention apparaîtront à la lecture de la description détaillée qui suit et qui est faite en référence aux dessins annexés dans lesquels :
- la figure 1 déjà décrite représente la structure d'un réseau neuronal de l'art antérieur ;
- la figure 2 déjà décrite représente un schéma simplifié de neurone ;
- la figure 3 déjà décrite représente le neurone auquel est appliqué un courant représentant un poids post-synaptique issu d'une mémoire ;
- la figure 4 représente un exemple de courbes dispersées de transistors de caractéristiques géométriques en principe identiques ;
- la figure 5 représente le schéma de principe du convertisseur numérique-analogique selon l'invention ;
- la figure 6 représente un premier mode de réalisation d'un circuit neuromorphique utilisant un convertisseur selon l'invention ;
- la figure 7 représente un deuxième mode de réalisation d'un circuit neuromorphique utilisant un convertisseur selon l'invention.

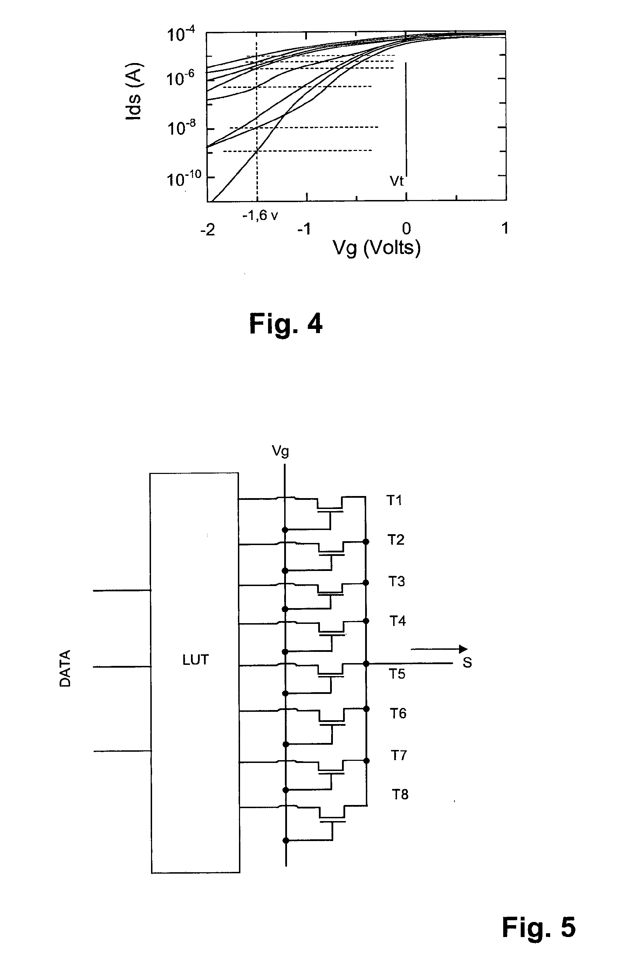

Sur la figure 4, on a représenté à titre d'exemple un ensemble de caractéristiques courant-tension de transistors ayant tous les mêmes dimensions nominales et la même technologie de fabrication. Il s'agit de très petits transistors dont la longueur de canal est de 10 nanomètres. Huit courbes de valeurs de transconductance sont représentées, correspondant à des transistors nominalement identiques.

En abscisse on a porté la tension grille-source Vg en échelle linéaire en volts et en ordonnée la valeur du courant drain-source Ids en échelle logarithmique. La tension drain-source est de 1 volt, mais le principe reste le même pour une tension de polarisation plus faible. On observe une très grande dispersion des courbes, notamment pour une tension Vg sous le seuil de conduction Vt du transistor, ici un seuil d'environ 0 volt mais le seuil pourrait être supérieur ou inférieur à 0. La dispersion augmente lorsque la tension grille-source s'écarte plus du seuil. Si on se place par exemple à une tension grille-source de -1,6 volts pour un seuil de 0 volt, les courants générés par ces huit transistors varient entre environ 10⁻⁹ et 10⁻⁵ ampères. Ces courbes ont été relevées pour des transistors de longueur effective de canal 10 nanomètres destinées à des circuits intégrés de très haute densité.

La forte variabilité des courants de fuite peut être due à une présence variable de dopants indésirables dans le centre du canal, le centre du canal étant très proche des sources et drains dopés du transistor lorsque le transistor est de très petite taille et lorsque le dopant du canal est de même nature que celui des source et drain. Elle peut être due aussi aux fluctuations locales de différents paramètres géométriques tels que l'épaisseur de l'oxyde de grille, la rugosité des gravures, etc. La variabilité peut être due également à d'autres facteurs : permittivité de l'oxyde de grille, taille des grains métalliques, granularité du dopage.

La figure 5 représente le principe du convertisseur numérique-analogique à sortie en courant selon l'invention. Il comprend un circuit de sélection LUT qui est une table numérique de correspondance (en anglais : "look-up-table") recevant comme entrée un mot numérique "DATA" de p bits à convertir, ici par exemple un mot de 3 bits, et fournissant sur ses sorties un code numérique servant à sélectionner un ou plusieurs transistors d'un ensemble de m transistors. La table de correspondance LUT comprend donc m sorties fournissant un signal logique haut ou bas selon la valeur des bits du mot appliqué à l'entrée. Par exemple, le niveau haut sur la sortie signifie la sélection d'un transistor et le niveau bas signifie l'absence de sélection. Dans l'exemple le plus simple, la table comporte m=2^{p} sorties et elle établit un niveau logique haut sur une sortie et une seule en fonction du mot d'entrée, les autres sorties étant au niveau bas. Mais dans d'autres exemples la table possède m sorties, m différent de 2^{p}, et peut placer une ou plusieurs sorties au niveau logique haut.

Dans l'exemple représenté sur la figure 5, on a supposé que l'ensemble de transistors comprend m=8 transistors T1 à T8 qui ont tous les mêmes caractéristiques physiques nominales (mêmes longueurs, largeurs, profondeurs et concentrations en dopants). Chaque sortie est appliquée au drain d'un transistor respectif pour lui appliquer une tension d'alimentation si le transistor est sélectionné mais pas de tension d'alimentation s'il n'est pas sélectionné. Les sources des transistors sont toutes reliées à une sortie commune S du convertisseur. Cette sortie constitue une sortie en courant. Les grilles de tous les transistors sont portées à un potentiel nominal commun Vg, de préférence comme on l'a dit un potentiel au-dessous du seuil de conduction Vt du transistor ; un courant qu'on peut appeler courant de fuite passe alors dans le transistor à la condition toutefois qu'il soit sélectionné par la table de correspondance. La sortie S délivre un courant de fuite global ; ce courant est la somme des courants de fuite des transistors qui reçoivent une tension d'alimentation (niveau logique haut fourni par la table de correspondance) sur leur drain ; les autres transistors ne fournissent pas de courant de fuite.

En raison du fait que les transistors, bien qu'identiques en théorie, ont des courants de fuite différents mais stables dans le temps, on remplit la table de correspondance avec des données qui font correspondre à chaque mot d'entrée un courant de sortie représentant une valeur analogique du mot d'entrée. Le remplissage de la table est fait à partir de mesures effectuées sur le circuit. On recherche à partir de ces mesures les courants ou sommes de courants de transistors qui représentent le mieux les valeurs analogiques désirées pour chaque valeur de mot numérique à l'entrée du convertisseur. On remplit la table en conséquence pour que l'application d'un mot numérique à l'entrée entraîne la sélection d'un transistor ou d'un groupe de transistors dont la somme des courants de fuite représente la valeur analogique désirée pour représenter ce mot numérique. Statistiquement, la grande variabilité des caractéristiques des transistors permet de trouver une sélection aboutissant à une valeur suffisamment proche de la valeur désirée.

La table de correspondance qui en résulte est différente de celle qu'on obtiendrait si les transistors avaient tous des caractéristiques identiques aux caractéristiques nominales.

Pour mesurer les courants de fuite des différents transistors, le plus simple est d'évaluer les courants fournis par toutes les combinaisons possibles de 1 à m transistors, puis de sélectionner une série de 2^{p} valeurs qui représentent au mieux une valeur analogique acceptable pour un mot d'entrée donné. On charge dans la table à chacune des 2^{p} adresses de la table un mot qui représente la combinaison de transistors à activer pour obtenir de la meilleure manière possible cette valeur.

Une manière de mesurer le courant de fuite d'un transistor consiste à relier la source du transistor à une capacité (analogue au neurone de la figure 2) reliée à un comparateur à seuil, à appliquer des impulsions successives de tension au drain de ce transistor (dont la grille est à la tension nominale Vg), et à compter le nombre N d'impulsions de largeur constante dt qui aboutissent au basculement du comparateur à seuil. Ce nombre est d'autant plus faible que le courant de fuite du transistor est plus grand. La durée des impulsions sera choisie brève pour une mesure fine du courant de fuite. Si la mesure est faite par un neurone ou un pseudo-neurone de capacité C_{nd} et de tension de seuil Vth, la valeur du courant de fuite d'un transistor donné relié à ce neurone sera donnée par la formule I = C_{nd}.Vth/N.dt, en supposant qu'on néglige dans cette mesure le courant de fuite naturel du neurone lui-même.

En utilisation, après avoir chargé la table de correspondance en fonction des mesures faites, on applique un mot à convertir à l'entrée du convertisseur, c'est-à-dire à l'entrée de la table de correspondance, et on utilise le courant analogique sur la sortie S.

Selon l'invention, une application principale de ce convertisseur est l'incorporation du convertisseur à un circuit neuromorphique tel que celui de la figure 1.

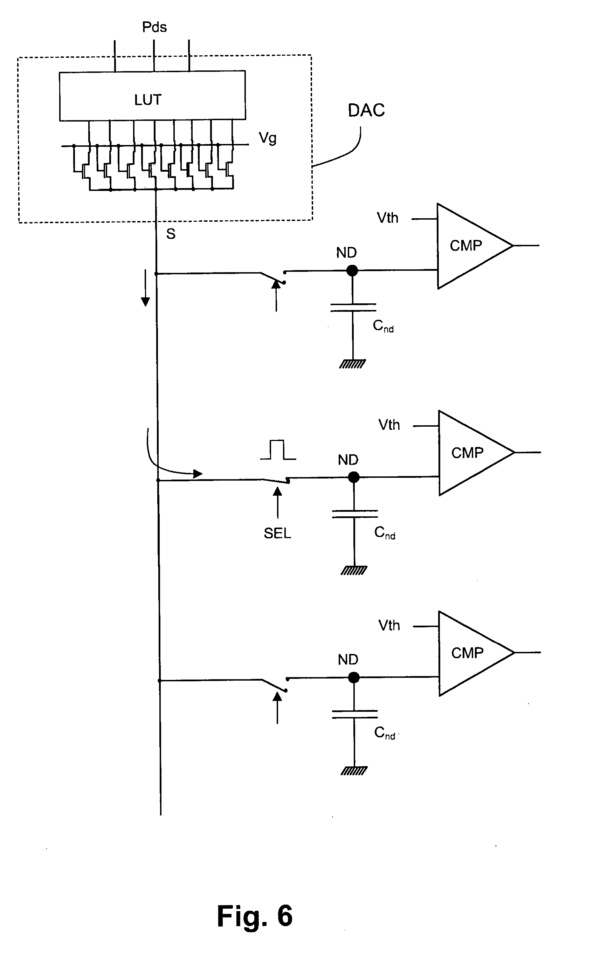

La figure 6 représente une première variante de réalisation dans laquelle il y a un seul convertisseur numérique-analogique pour l'ensemble des neurones du circuit. On a représenté trois neurones sous la même forme que celui de la figure 2, à savoir avec un noeud capacitif ND et un comparateur à seuil CMP. Un neurone post-synaptique désigné par le bus post-synaptique peut être sélectionné par un signal SEL issu du décodeur DEC de la figure 1. Ce neurone reçoit alors le courant de sortie du convertisseur numérique-analogique DAC de la figure 5 ; le convertisseur a reçu en même temps le poids synaptique Pds fourni par le bus post-synaptique et le courant fourni au neurone est un courant analogique représentant ce poids.

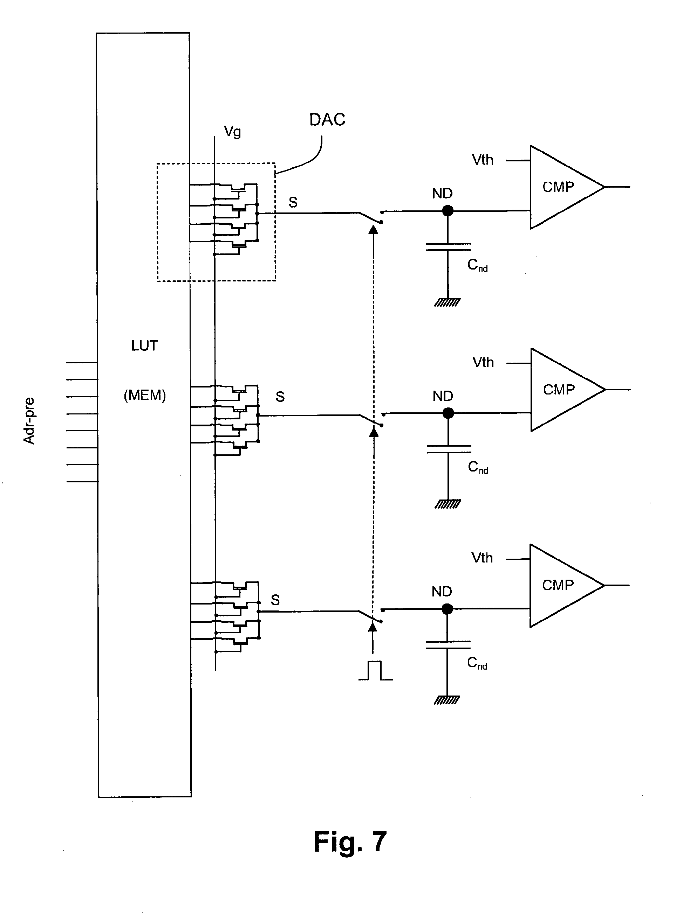

La figure 7 représente une autre variante dans laquelle il y a une structure de convertisseur numérique-analogique associée à chaque neurone et non pas une structure de convertisseur globale pour tous les neurones. La table de correspondance LUT du convertisseur se confond alors avec la mémoire MEM de la figure 1, et cette table désigne à la fois un neurone post-synaptique, donc un ensemble de m transistors associé à ce neurone, et le ou les transistors à sélectionner dans cet ensemble de m transistors. Sur la figure 7 on a supposé que m = 4.

La table de correspondance est donc une table numérique qui fait correspondre une adresse pre-synaptique Adr-pre (l'adresse du neurone qui a émis un évènement) avec une sélection d'un ou plusieurs transistors parmi m transistors. Le poids synaptique représenté par cette sélection est inscrit dans la table sous une forme numérique qui est directement un code de sélection des transistors. Si le neurone pré-synaptique fait appel à plusieurs neurones post-synaptiques, la table de correspondance fait correspondre à une adresse pré-synaptique plusieurs groupes de transistors correspondant à des neurones post-synaptiques différents. L'impulsion de courant peut-être appliquée simultanément à tous les neurones post-synaptique, alors que dans la réalisation de la figure 6 une impulsion de courant ne peut être appliquée par un convertisseur qu'à un neurone post-synaptique à la fois. Sur la figure 7, on a représenté à titre d'exemple des interrupteurs entre chaque ensemble de transistors et le neurone associé, la fermeture simultanée de tous les interrupteurs permettant l'application d'une impulsion de courant de durée dt à ceux des neurones qui sont sélectionnés et avec une amplitude respective selon les transistors sélectionnés pour chacun d'eux.

## Revendications

1. Convertisseur numérique-analogique **caractérisé en ce qu'il** comporte :
- un ensemble de plusieurs transistors (T1-T8) de caractéristiques géométriques nominales identiques mais de caractéristiques courant-tension dispersées telles que lorsqu'on applique une tension grille-source constante aux différents transistors il circule dans le transistor un courant variable en fonction de la dispersion,
- une table numérique de correspondance ayant une entrée numérique pour recevoir un mot à convertir et une sortie de sélection pour sélectionner parmi l'ensemble de transistors, en fonction du mot à convertir, un transistor ou un groupe de transistors fournissant un courant de valeur désirée représentant ce mot sous forme analogique,
- une sortie en courant fournissant le courant délivré par le transistor ou le groupe de transistors sélectionnés, recevant tous une tension grille-source nominale (Vg),
- et des moyens pour charger dans la table numérique de correspondance à une adresse déterminée une donnée déterminant la sélection du transistor ou du groupe de transistors, en fonction de caractéristiques tension-courant réelles mesurées des différents transistors de l'ensemble, pour établir une correspondance entre des mots à convertir et des valeurs de courant obtenues par la sélection des transistors, la table de correspondance étant différente de celle qu'on aurait si les transistors avaient tous les dites caractéristiques nominales.

2. Convertisseur numérique-analogique selon la revendication 1, **caractérisé en ce que** la tension grille-source appliquée aux transistors est une tension inférieures à un seuil Vt de mise en conduction du transistor.

3. Convertisseur numérique-analogique selon l'une des revendications 1 et 2, **caractérisé en ce que** la sortie de sélection de la table de correspondance comprend plusieurs conducteurs de sortie connectés chacun au drain d'un transistor respectif, les sources des transistors étant toutes reliées à la sortie du convertisseur, de sorte que la sortie du convertisseur fournit la somme des courants traversant ceux des transistors qui sont sélectionnés par la table, les autres transistors ne fournissant pas de courant.

4. Convertisseur selon la revendication 3, **caractérisé en ce que** les conducteurs de sortie de la table ont deux états qui sont un premier état en haute impédance dans lequel les drains des transistors ne reçoivent pas de tension d'alimentation, et un deuxième état dans lequel les drains des transistors reçoivent une alimentation et peuvent donc fournir un courant.

5. Circuit neuromorphique comprenant
- un réseau de neurones (RN) identifiés chacun par une adresse de neurone dans le réseau, chaque neurone pouvant recevoir et traiter au moins un signal d'entrée puis émettre plus tard sur une sortie du neurone un signal représentant un évènement qui se produit à l'intérieur du neurone,
- une mémoire programmable (MEM) adressable par l'adresse d'un neurone ayant émis un signal d'évènement représentant un résultat de l'activité du neurone, la mémoire contenant à cette adresse une donnée numérique comprenant une ou plusieurs adresses de neurones post-synaptiques et un poids post-synaptique respectif associé à chaque adresse post-synaptique,
- des moyens (CTRL) pour extraire de la mémoire la donnée relative à un neurone, après que ce neurone ait émis un signal d'évènement représentant un résultat de l'activité du neurone,
- un convertisseur numérique-analogique (DAC) pour appliquer à l'entrée d'un neurone post-synaptique identifié par une adresse contenue dans la donnée une impulsion de courant dont l'amplitude représente le poids post-synaptique associé à cette adresse dans la donnée, **caractérisé en ce que** le convertisseur numérique-analogique comprend
- au moins un ensemble de plusieurs transistors (T1-T8) de caractéristiques géométriques nominales identiques mais de caractéristiques courant-tension dispersées telles que lorsqu'on applique une tension grille-source constante aux différents transistors il circule dans le transistor un courant variable en fonction de la dispersion,
- une table numérique de correspondance (LUT) ayant une entrée numérique et une sortie de sélection pour sélectionner en fonction de l'entrée numérique un transistor ou un groupe de transistors parmi l'ensemble,
- une sortie en courant (S) fournissant le courant délivré par le transistor ou le groupe de transistors sélectionnés, recevant tous une tension grille-source nominale (Vg),
- et des moyens pour charger dans la table numérique de correspondance des données déterminées déterminant la sélection de transistors, en fonction de caractéristiques courant-tension réelles mesurées des différents transistors de l'ensemble, la table de correspondance étant différente de celle qu'on aurait si les transistors avaient tous les dites caractéristiques nominales.

6. Circuit neuromorphique selon la revendication 5, **caractérisé en ce que** le convertisseur numérique-analogique est commun à tous les neurones, l'ensemble de transistors qui effectue la conversion en courant étant commun à tous les neurones.

7. Circuit neuromorphique selon la revendication 5, **caractérisé en ce qu'il** comporte un ensemble de m transistors associé à chaque neurone et placé en amont du noeud capacitif du neurone, et **en ce que** la table de correspondance est constituée par la mémoire programmable (MEM) qui reçoit une adresse de neurone pré-synaptique et qui sélectionne au moins un ensemble de m transistors et, dans cet ensemble, un transistor ou un groupe de transistors, pour appliquer à un neurone associé un courant correspondant au transistor ou au groupe de transistors sélectionné.

## Patentansprüche

1. Digital-Analog-Wandler, **dadurch gekennzeichnet, dass** er aufweist:
- eine Gruppe aus mehreren Transistoren (T1-T8) mit nominal identischen geometrischen Merkmalen, aber mit derart dispergierten Strom-Spannungs-Merkmalen, dass bei Anwendung einer konstanten Gitter-Quelle-Spannung auf die verschiedenen Transistoren in dem Transistor ein in Abhängigkeit von der Dispersion variabler Strom fließt,
- eine digitale Lookup-Tabelle mit einem digitalen Eingang für den Empfang eines zu konvertierenden Worts und einem Selektionsausgang, um aus der Transistorengruppe in Abhängigkeit von dem zu konvertierenden Wort einen Transistor oder eine Transistorengruppe auszuwählen, der/die einen Strom mit dem gewünschten Wert liefert, der dieses Wort in analoger Form repräsentiert,
- einen Stromausgang, der den von dem ausgewählten Transistor oder der ausgewählten Transistorengruppe, die alle eine nominale Gitter-Quelle-Spannung (Vg) erhalten, bereitgestellten Strom liefert,
- und Mittel, um in der digitalen Lookup-Tabelle an einer bestimmten Adresse eine Angabe zu laden, die die Auswahl des Transistors oder der Transistorengruppe in Abhängigkeit von den tatsächlichen Spannungs-Strom-Merkmalen bestimmt, die von den diversen Transistoren der Gruppe gemessen wurden, um eine Entsprechung zwischen zu konvertierenden Wörtern und durch Transistorauswahl erhaltenen Stromwerten zu erstellen, wobei sich die Lookup-Tabelle von der Tabelle unterscheidet, die man haben würde, wenn die Transistoren alle die besagten nominalen Merkmale hätten.

2. Analog-Digital-Wandler nach Anspruch 1, **dadurch gekennzeichnet, dass** die auf die Transistoren angewendete Gitter-Quelle-Spannung eine Spannung ist, die kleiner als ein Einschaltgrenzwert Vt des Transistors ist.

3. Analog-Digital-Wandler nach einem der Ansprüche 1 und 2, **dadurch gekennzeichnet, dass** der Selektionsausgang der Lookup-Tabelle mehrere Ausgangsleiter umfasst, die jeweils mit dem Drain eines jeweiligen Transistors verbunden sind, wobei die Quellen der Transistoren alle mit dem Ausgang des Wandlers derart verbunden sind, dass der Ausgang des Wandlers die Summe der Ströme liefert, die die der Transistoren durchqueren, die von der Tabelle ausgewählt sind, wobei die anderen Transistoren keinen Strom liefern.

4. Wandler nach Anspruch 3, **dadurch gekennzeichnet, dass** die Ausgangsleiter der Tabelle zwei Zustände haben, die ein erster Zustand in hoher Impedanz, in dem die Drains der Transistoren keine Versorgungsspannung erhalten, und ein zweiter Zustand, in dem die Drains der Transistoren eine Versorgung erhalten und demzufolge einen Strom liefern können, sind.

5. Neuromorpher Schaltkreis, der umfasst:
- ein Netzwerk aus Neuronen (RN), die im Netzwerk jeweils durch eine Neuronenadresse identifiziert sind, wobei jedes Neuron mindestens ein Eingangssignal empfangen und verarbeiten und dann später über einen Ausgang des Neurons ein Signal senden kann, das ein Ereignis repräsentiert, das in dem Neuron stattfindet,
- einen programmierbaren Speicher (MEM), der durch die Adresse eines Neurons, das ein Ereignissignal gesendet hat, das ein Ergebnis der Aktivität des Neurons repräsentiert, adressierbar ist, wobei der Speicher, der an dieser Adresse eine numerische Angabe enthält, eine oder mehrere Adressen postsynaptischer Neuronen und ein jeweiliges postsynaptisches Gewicht umfasst, das jeder postsynaptischen Adresse zugeordnet ist,
- Mittel (CTRL), um aus dem Speicher die sich auf ein Neuron beziehende Angabe zu extrahieren, nachdem dieses Neuron ein Ereignissignal gesendet hat, das ein Ergebnis der Aktivität des Neurons repräsentiert,
- einen Analog-Digital-Wandler (DAC), um auf den Eingang eines von einer in der Angabe enthaltenen Adresse identifizierten postsynaptischen Neurons einen Stromimpuls anzuwenden, dessen Amplitude das dieser Adresse in der Angabe zugeordnete postsynaptische Gewicht repräsentiert,
**dadurch gekennzeichnet, dass** der Digital-Analog-Wandler umfasst:
- mindestens eine Gruppe aus mehreren Transistoren (T1-T8) mit nominal identischen geometrischen Merkmalen, aber mit derart dispergierten Strom-Spannungs-Merkmalen, dass bei Anwendung einer konstanten Gitter-Quelle-Spannung auf die verschiedenen Transistoren in dem Transistor ein in Abhängigkeit von der Dispersion variabler Strom fließt,
- eine digitale Lookup-Tabelle (LUT) mit einem digitalen Eingang und einem Selektionsausgang, um aus der Gruppe in Abhängigkeit von dem digitalen Eingang einen Transistor oder eine Transistorengruppe auszuwählen,
- einen Stromausgang (S), der den von dem ausgewählten Transistor oder der ausgewählten Transistorengruppe, die alle eine nominale Gitter-Quelle-Spannung (Vg) erhalten, bereitgestellten Strom liefert,
- und Mittel, um in der digitalen Lookup-Tabelle bestimmte Daten zu laden, die die Transistorenauswahl in Abhängigkeit von den tatsächlichen Spannungs-Strom-Merkmalen bestimmt, die von den diversen Transistoren der Gruppe gemessen wurden, wobei die sich Lookup-Tabelle von der Tabelle unterscheidet, die man haben würde, wenn die Transistoren alle die besagten nominalen Merkmale hätten.

6. Neuromorpher Schaltkreis nach Anspruch 5, **dadurch gekennzeichnet, dass** der Analog-Digital-Wandler allen Neuronen gemeinsam ist, wobei die Transistorengruppe, die die Konvertierung in Strom durchführt, allen Neuronen gemeinsam ist.

7. Neuromorpher Schaltkreis nach Anspruch 5, **dadurch gekennzeichnet, dass** er eine Gruppe aus m Transistoren aufweist, die jedem Neuron zugeordnet und vor dem kapazitiven Knoten des Neurons platziert ist, und dass die Lookup-Tabelle von dem programmierbaren Speicher (MEM) gebildet ist, der eine Adresse eines präsynaptischen Neurons empfängt und der mindestens eine Gruppe aus m Transistoren auswählt und aus dieser Gruppe einen Transistor oder eine Transistorengruppe, um auf ein zugeordnetes Neuron einen Strom anzuwenden, der dem ausgewählten Transistor oder der ausgewählten Transistorengruppe entspricht.

## Claims

1. Digital-to-analogue converter, **characterized in that** it comprises :
- a set of several transistors (T1-T8) of identical nominal geometrical characteristics but of dispersed current-voltage characteristics such that, when a constant gate-source voltage is applied to the different transistors, a current that is variable as a function of the dispersion circulates in the transistor,
- a digital look-up table having a digital input for receiving a word to be converted and a selection output for selecting from the set of transistors, as a function of the word to be converted, a transistor or a group of transistors supplying a current of desired value representing this word in analogue form,
- a current output supplying the current delivered by the selected transistor or group of transistors, all receiving a nominal gate-source voltage (Vg),
- and means for loading into the digital look-up table, at a determined address, a datum determining the selection of the transistor or of the group of transistors, as a function of real measured voltage-current characteristics of the different transistors of the set, to establish a look-up between words to be converted and current values obtained by the selection of the transistors, the look-up table being different from that which would be obtained if the transistors all had said nominal characteristics.

2. Digital-to-analogue converter according to Claim 1, **characterized in that** the gate-source voltage applied to the transistors is a voltage less than a switch-on threshold Vt of the transistor.

3. Digital-to-analogue converter according to one of Claims 1 and 2, **characterized in that** the selection output of the look-up table comprises a number of output conductors each connected to the drain of a respective transistor, the sources of the transistors all being linked to the output of the converter, so that the output of the converter supplies the sum of the currents passing through those of the transistors which are selected by the table, the other transistors not supplying any current.

4. Converter according to Claim 3, **characterized in that** the output conductors of the table have two states which are a first high impedance state in which the drains of the transistors do not receive power supply voltage, and a second state in which the drains of the transistors receive a power supply and can therefore supply a current.

5. Neuromorphic circuit comprising
- a neuronal network (RN) with each neuron identified by a neuron address in the network, each neuron being able to receive and process at least one input signal then later emit to an output of the neuron a signal representing an event which occurs inside the neuron,
- a programmable memory (MEM) which can be addressed by the address of a neuron having emitted an event signal representing a result of the activity of the neuron, the memory containing at this address a digital datum comprising one or more post-synaptic neuron addresses and a respective post-synaptic weight associated with each post-synaptic address,
- means (CTRL) for extracting from the memory the datum relating to a neuron, after this neuron has emitted an event signal representing a result of the activity of the neuron,
- a digital-to-analogue converter (DAC) for applying, to the input of a post-synaptic neuron identified by an address contained in the datum, a current pulse, the amplitude of which represents the post-synaptic weight associated with this address in the datum,
**characterized in that** the digital-to-analogue converter comprises
- at least one set of several transistors (T1-T8) of identical nominal geometrical characteristics but of dispersed current-voltage characteristics such that, when a constant gate-source voltage is applied to the different transistors, a current that is variable as a function of the dispersion circulates in the transistor,
- a digital look-up table (LUT) having a digital input and a selection output for selecting, as a function of the digital input, a transistor or a group of transistors from the set,
- a current output (S) supplying the current delivered by the selected transistor or group of transistors, all receiving a nominal gate-source voltage (Vg),
- and means for loading into the digital look-up table determined data determining the selection of transistors, as a function of real measured current-voltage characteristics of the different transistors of the set, the look-up table being different from the one which would be obtained if the transistors all had said nominal characteristics.

6. Neuromorphic circuit according to Claim 5, **characterized in that** the digital-to-analogue converter is common to all the neurons, the set of transistors which performs the current conversion being common to all the neurons.

7. Neuromorphic circuit according to Claim 5, **characterized in that** it comprises a set of m transistors associated with each neuron and placed upstream of the capacitive node of the neuron, and **in that** the look-up table consists of the programmable memory (MEM) which receives a pre-synaptic neuron address and which selects at least one set of m transistors and, in this set, a transistor or a group of transistors, in order to apply to an associated neuron a current corresponding to the selected transistor or group of transistors.
